Europäisches Patentamt

European Patent Office

Office européen des brevets

(19)

(11)  EP 1 388 896 A1

(12)  **DEMANDE DE BREVET EUROPEEN**

(43) Date de publication:
    **11.02.2004  Bulletin 2004/07**

(51) Int Cl.7: **H01L 27/12**, H01L 27/11

(21) Numéro de dépôt: **03300083.7**

(22) Date de dépôt: **08.08.2003**

(84) Etats contractants désignés:
    **AT BE BG CH CY CZ DE DK EE ES FI FR GB GR
    HU IE IT LI LU MC NL PT RO SE SI SK TR**
    Etats d'extension désignés:
    **AL LT LV MK**

(30) Priorité: **08.08.2002  FR 0210097**

(71) Demandeur: **SOISIC
    38054 Grenoble (FR)**

(72) Inventeurs:
    • **Dufourt, Denis
      38240, Meylan (FR)**
    • **Mayor, M. Cedric
      38000, Grenoble (FR)**

(74) Mandataire: **de Beaumont, Michel et al
    1bis, rue Champollion
    38000 Grenoble (FR)**

(54)  **Mémoire sur substrat du type silicium sur isolant.**

(57)     L'invention concerne une mémoire SRAM sur substrat SOI comprenant un réseau de rangées et de colonnes de cellules mémoire 6T à deux inverseurs et deux transistors interrupteurs, chaque cellule étant reliée à deux lignes de bits (**BL0, $\overline{BL0}$**) et à une des lignes de mots. Chaque cellule mémoire comprend deux premières régions du premier type de conductivité, chaque première région comprenant les drains ou les sources de premier (N1, N2) et troisième (A1, A2) transistors, et étant en contact avec une seconde région du second type de conductivité comprenant le drain ou la source d'un second transistor (P1, P2), les première et seconde régions étant court-circuitées par un matériau conducteur, les pistes conductrices (42, 43, 44, 45) de premier niveau participant aux interconnexions entre les inverseurs, et aux interconnexions entre les transistors interrupteurs et la ligne de mots étant parallèles aux lignes de bits.

Fig 6

EP 1 388 896 A1

**Description**

La présente invention concerne les mémoires comprenant un réseau de rangées et de colonnes de cellules mémoire réalisées sur un substrat du type silicium sur isolant (SOI).

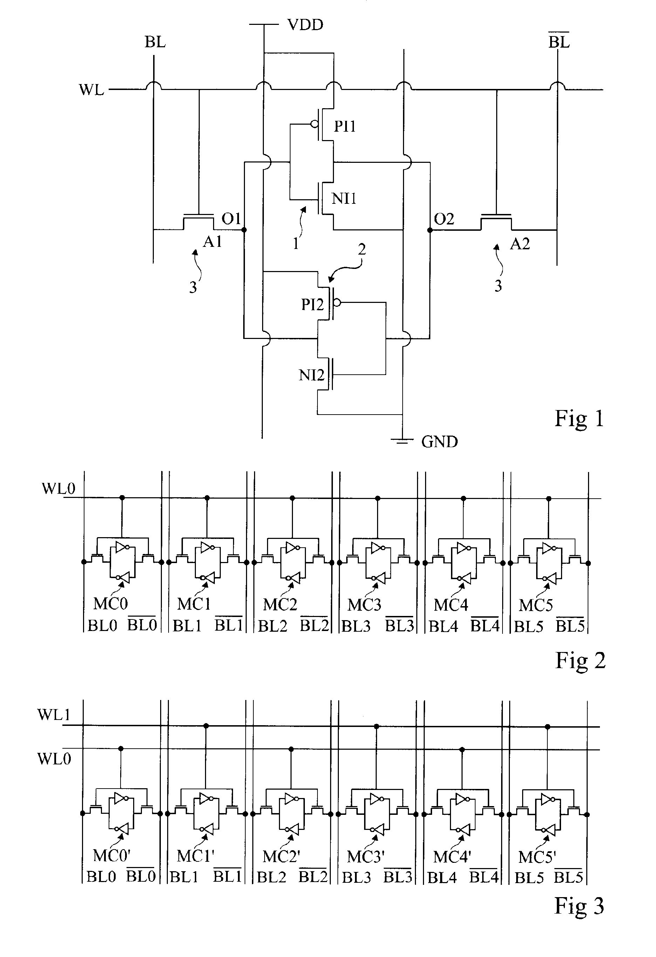

La figure 1 représente de façon schématique une cellule d'une mémoire statique du type à accès aléatoire (SRAM) de structure classique à six transistors, dite cellule 6T. La cellule mémoire comprend des inverseurs 1, 2, connectés en antiparallèle. Les entrées respectives des inverseurs 1, 2, sont reliées à des lignes de bits respectives **BL, $\overline{\text{BL}}$,** par l'intermédiaire d'interrupteurs 3, commandés par un signal de sélection de rangées transporté par une ligne de mots WL. Chaque inverseur 1, 2, est alimenté par une tension haute VDD et une tension basse GND, couramment la masse.

Pour écrire une information dans la cellule mémoire, on applique sur l'une des lignes de bits **BL** ou **$\overline{\text{BL}}$** une tension VDD et sur l'autre une tension GND. Ensuite, les interrupteurs 3 sont fermés pour fixer l'état des entrées et des sorties des inverseurs 1 et 2. Les interrupteurs 3 sont ensuite ouverts et l'état des signaux aux bornes des inverseurs 1 et 2 se maintient.

Pour lire une information dans la cellule mémoire, chacune des lignes de bits **BL** et **$\overline{\text{BL}}$** est préchargée à une tension comprise entre les tensions VDD et GND, puis les interrupteurs 3 sont fermés de manière que les tensions sur les lignes de bits varient en fonction de l'état des signaux aux bornes des inverseurs 1 et 2. Un amplificateur de lecture (non représenté) connecté aux lignes de bits fournit une information binaire en rapport avec l'information conservée dans la cellule mémoire.

L'inverseur 1 comprend un transistor MOS à canal P, PI1, en série avec un transistor MOS à canal N, NI1. La source du transistor PI1 est reliée à la tension VDD et la source du transistor NI1 est reliée à la tension GND. Les drains des transistors PI1 et NI1 sont connectés en un point O2. Les grilles des transistors PI1 et NI1 sont connectées en un point O1. De façon similaire, l'inverseur 2 comprend des transistors PI2 et NI2 reliés comme les transistors PI1 et NI1, les grilles des transistors PI2 et NI2 étant connectées à la borne O2 et les drains communs des transistors PI2 et NI2 étant reliés à la borne O1. Les interrupteurs 3 sont constitués de transistors MOS M1 et M2, de façon générale à canal N.

La figure 2 représente une rangée d'une mémoire SRAM classique. On a représenté six cellules mémoire 6T MC0 à MC5. De façon classique, à une rangée de cellules mémoire correspond une unique ligne de mots WL0 et à une colonne de cellules mémoire correspondent deux lignes de bits **(BLj** et **$\overline{\text{BLj}}$, j** variant de 0 à 5). Dans une telle mémoire, lors de l'écriture ou de la lecture de données dans une cellule mémoire, il est nécessaire de sélectionner, par la ligne de mots WL0, toutes les cellules mémoire de la rangée où se trouve la cellule mémoire recherchée. Il en résulte une consommation électrique élevée.

Pour diminuer la consommation, on cherche à réduire le nombre de cellules mémoire activées lors d'un accès à la mémoire. Une possibilité consiste à utiliser plusieurs lignes de mots par rangée de cellules mémoire sachant que chaque ligne de mots active un sous-ensemble de cellules mémoire de la rangée. Ce type d'architecture appelé "multi-lignes" nécessite donc de faire passer sur les cellules mémoire des pistes métalliques correspondant aux différentes lignes de mots. En réduisant le nombre de cellules mémoire sélectionnées à chaque opération d'écriture et/ou de lecture, on diminue la consommation de la mémoire.

La figure 3 représente une rangée d'un exemple de réalisation d'une mémoire SRAM "multi-lignes" pour laquelle deux lignes de mots WL0, WL1 sont associées à chaque rangée. On a représentée six cellules mémoire 6T MC0 à MC5'. Chaque ligne de mots WL0, WL1 est connectée à une cellule mémoire sur deux. A chaque opération de lecture/d'écriture, seule la moitié des cellules mémoire de la rangée est donc sélectionnée.

On cherche également à obtenir une mémoire pour laquelle les opérations de lecture et d'écriture peuvent être réalisées à une fréquence élevée. Pour ce faire, on cherche à réduire la capacité des lignes de bits en diminuant la hauteur des cellules mémoire.

En outre, on cherche de façon générale à diminuer la surface totale des cellules mémoire.

Toutefois, dans le cas où l'on souhaite réaliser une mémoire "multi-lignes", il est souvent difficile de réaliser une cellule mémoire à faible surface, et en particulier à faible hauteur.

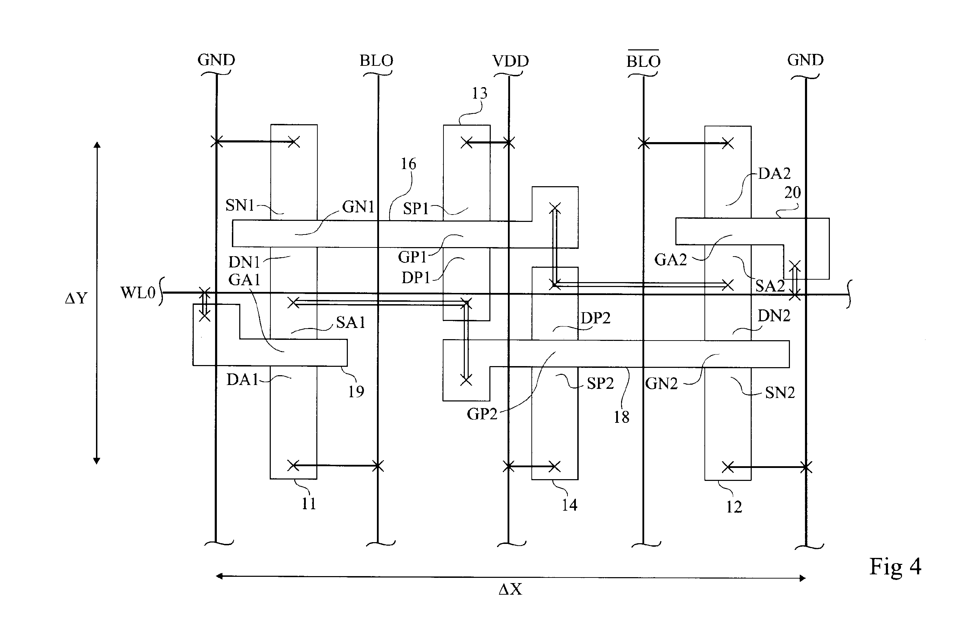

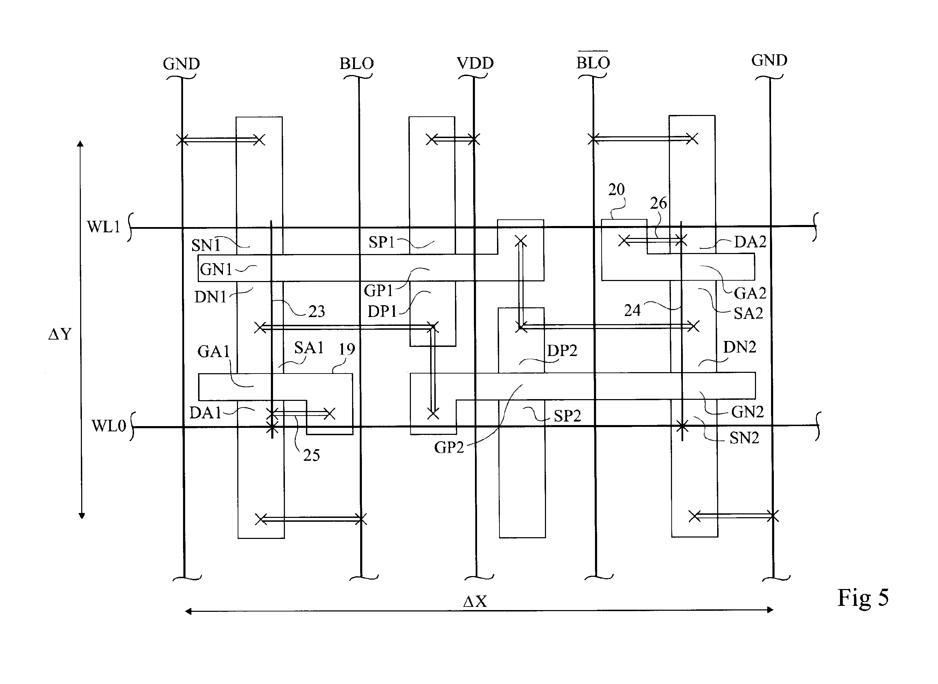

Pour illustrer une telle difficulté, on a représenté en figure 4 un exemple classique de topologie de la cellule mémoire 6T MC0 de la mémoire de la figure 2, et en figure 5 un exemple classique de topologie de la cellule mémoire 6T MC0 de la mémoire de la figure 3.

La figure 4 représente, de façon schématique, la cellule mémoire MC0 de la figure 2 dans laquelle le circuit électrique de la figure 1 est réalisé par une technologie à un niveau de silicium polycristallin et trois niveaux de métallisation réalisés sur substrat SOI. D'autres niveaux de silicium polycristallin et de métallisation peuvent être présents et utilisés.

Les surfaces délimitées par un trait fin correspondent à des zones actives du substrat semiconducteur ou à des bandes de silicium polycristallin déposées sur le substrat et correspondant aux grilles de transistors MOS. Bien que la vue ne soit pas représentée à l'échelle, les dimensions et positions relatives de chaque région sont conservées de façon à représenter l'encombrement réel du circuit intégré. Les traits doubles correspondent à des bandes de métal de niveau un. Les traits noirs épais horizontaux correspondent à des bandes de métal de niveau deux et enfin les traits noirs épais verticaux correspondent à des bandes de métal de niveau trois. Les croix représentent des contacts reliant, à travers les couches isolantes situées entre les niveaux de métallisation et le niveau de silicium polycristallin, des bandes métalliques à des zones actives ou à des bandes de silicium polycristallin ou des vias reliant, à travers les couches isolantes situées entre les niveaux de métallisation, des bandes métalliques à d'autres bandes métalliques. Par souci de clarté, les bandes métalliques ne sont pas représentées avec des surfaces proportionnelles aux surfaces des zones actives. Toutefois, la position de chaque trait est en accord avec la position réelle de la bande métallique correspondante dans le circuit intégré.

Une zone active 11 correspond au transistor MOS A1, au transistor MOS N1 et à la liaison entre ces transistors. Une zone active 12 correspond au transistor MOS A2, au transistor MOS N2, et à la liaison entre ces transistors. Des zones actives 13, 14 correspondent respectivement aux transistors MOS P1, P2. Les grilles GN1, GP1 des transistors MOS respectifs N1, P1 correspondent à des portions d'une bande de silicium polycristallin 16. Les grilles GP2, GN2 des transistors MOS respectifs P2, N2 correspondent à des portions d'une bande de silicium polycristallin 18. Les grilles GA1, GA2 des transistors MOS A1, A2 correspondent à des portions respectives de bandes de silicium polycristallin 19, 20.

Les différentes pistes métalliques de niveau un, deux et trois sont utilisées pour relier les zones actives 11, 12, 13, 14 et les bandes de silicium polycristallin 16, 18, 19, 20 de façon à obtenir un schéma électrique équivalent au schéma représenté sur la figure 1. En particulier, la ligne de mots WL0 connectée aux grilles GA1, GA2 des transistors A1, A2 correspond dans le présent exemple à une bande métallique horizontale de niveau deux et les lignes d'alimentation GND, VDD et les lignes de bits **BL0**, **BL0** à des bandes métalliques verticales de niveau trois.

De façon à réduire la surface de la cellule mémoire, les contacts, vias et portions métalliques assurant la connexion entre les grilles GA1, GA2 des transistors A1, A2 et la ligne de mots WL0 sont disposés au niveau des bords verticaux de la cellule pour être mis en commun avec les cellules mémoire de la même rangée de part et d'autre de la cellule représentée.

La figure 5 représente un exemple de réalisation de la cellule mémoire MC0 de la mémoire "multilignes" de la figure 3 qui conserve une topologie semblable à celle de la figure 4 en ce qui concerne la disposition des transistors. Pour deux cellules adjacentes d'une même rangée, les grilles GA1, GA2 des transistors A1, A2 sont reliées à des lignes de mots différentes WL0, WL1. Les contacts, vias et portions métalliques assurant la connexion des grilles GA1, GA2 aux lignes de mots WL0, WL1 ne peuvent donc pas être partagés entre deux cellules mémoire adjacentes et doivent donc être placés à l'intérieur de la cellule.

Afin de pouvoir connecter les deux grilles GA1, GA2 des transistors A1 et A2 à l'une ou l'autre des lignes de mots WL0, WL1, il est nécessaire de prévoir deux pistes métalliques verticales 23, 24 connectées respectivement aux grilles GA1, GA2 des transistors A1, A2 et à l'une des lignes de mots WL0, WL1. Etant donné l'encombrement du premier niveau de métallisation, les pistes métalliques 23, 24 sont réalisées dans le deuxième niveau de métallisation. Les lignes de mots WL0, WL1 correspondent donc à des bandes métalliques de niveau trois, et les lignes d'alimentation GND, VDD et les lignes de bits **BL0**, **BL0** à des bandes métalliques de niveau deux.

Le déplacement des contacts, vias, et portions métalliques assurant le contact des grilles GA1, GA2 des transistors A1, A2 à l'intérieur de la cellule mémoire nécessite d'augmenter la hauteur de la cellule mémoire à cause de l'encombrement du premier niveau de métallisation. En outre, la présence des pistes 23, 24 au même niveau de métallisation que les lignes de bits **BL0**, **BL0** et les lignes d'alimentation GND, VDD nécessite d'augmenter la largeur de la cellule mémoire.

Dans une technologie de fabrication dans laquelle le plus petit motif a une longueur de 0,13 μm, on peut obtenir pour la cellule mémoire de la figure 4 une largeur ΔX de 2,80 μm, une hauteur ΔY de 1,10 μm et une surface de 3,08 μm². A titre de comparaison, la cellule mémoire de la figure 5 a une largeur ΔX de 2,56 μm, une hauteur ΔY de 1,54 μm et une surface de 3,9424 μm². On obtient donc une augmentation de 40% de la hauteur et une augmentation de 22% de la surface. Les capacités des lignes de bits **BL0**, **BL0** de la cellule mémoire "multi-lignes" de la figure 5 sont donc augmentées par rapport à celles de la mémoire de la figure 4. Les performances en terme de fréquence de lecture/d'écriture sont donc dégradées.

La présente invention vise à proposer une topologie de cellule mémoire réalisée sur un substrat SOI ayant une surface inférieure à celle d'une cellule mémoire classique.

La présente invention vise également à proposer une topologie de cellule mémoire réalisée sur un substrat SOI permettant d'obtenir une mémoire "multi-lignes" pour laquelle la surface et en particulier la hauteur de chaque cellule augmente peu par rapport à une cellule mémoire d'une mémoire à une seule ligne de mots par rangée.

Pour atteindre ces objets, la présente invention prévoit une mémoire SRAM comprenant un réseau de rangées et de colonnes de cellules mémoire 6T à deux inverseurs et deux transistors interrupteurs formées dans un substrat du type silicium sur isolant, les entrées des deux inverseurs de chaque cellule mémoire étant reliées à deux lignes de bits par l'intermédiaire des deux transistors interrupteurs commandés par un signal fourni par une ligne de mots, chaque cellule mémoire comportant six transistors dont les grilles correspondent à un même niveau d'un premier matériau conducteur et dont les interconnexions sont réalisées par des pistes conductrices d'au moins un deuxième matériau conducteur réparties sur trois niveaux, chaque inverseur comprenant un premier transistor d'un premier type de conductivité et un deuxième transistor d'un second type de conductivité, chaque interrupteur comprenant un troisième transistor du premier type de conductivité, dans laquelle chaque cellule mémoire comprend deux premières régions du premier type de conductivité, chaque première région comprenant les drains ou les sources d'un premier et d'un troisième transistors, et étant en contact avec une seconde région du second type de conductivité comprenant le drain ou la source d'un deuxième transistor, les première et seconde régions associées étant court-circuitées par un troisième matériau conducteur recouvrant lesdites première et seconde régions, la ligne de mots et les lignes de bits correspondant à des bandes conductrices de niveaux supérieurs au premier niveau, les pistes conductrices de premier niveau participant aux interconnexions entre les inverseurs, et aux interconnexions entre les transistors interrupteurs et la ligne de mots étant parallèles aux lignes de bits.

Selon un mode de réalisation de l'invention, une unique ligne de mots correspondant à une bande métallique de niveau deux ou trois est associée à une rangée, chaque cellule mémoire de la rangée étant reliée à ladite ligne de mots, les lignes de bits correspondant à des bandes métalliques perpendiculaires à la ligne de mots et d'un niveau différent du niveau de la ligne de mots.

Selon un mode de réalisation de l'invention, au moins deux lignes de mots, correspondant à des bandes métalliques de niveau deux ou trois, sont associées à une rangée, chaque cellule mémoire de la rangée étant reliée à l'une des lignes de mots, les lignes de bits correspondant à des bandes métalliques perpendiculaires aux lignes de mots et d'un niveau différent du niveau des lignes de mots.

Selon un mode de réalisation de l'invention, chaque cellule mémoire comporte au moins une piste conductrice de niveau un perpendiculaire aux lignes de mots et connectée à l'une des lignes de mots et à l'un des troisièmes transistors.

Selon un mode de réalisation de l'invention, chaque cellule mémoire, disposée entre deux autres cellules mémoire adjacentes de la même rangée, est reliée à deux lignes d'alimentation à une première tension, chaque ligne d'alimentation étant partagée entre la cellule mémoire et l'une des cellules mémoire adjacentes et correspondant à une bande conductrice du même niveau que les lignes de bits, parallèle aux lignes de bits et disposée sur le bord commun entre deux cellules adjacentes.

Selon un mode de réalisation de l'invention, les sources et les drains de premier et troisième transistors sont alignés parallèlement aux lignes de bits.

Selon un mode de réalisation de l'invention, chaque cellule mémoire comporte deux zones actives, chaque zone active comprenant l'une des premières régions et la seconde région associée, les zones actives étant sensiblement symétriques par rapport au centre de la cellule mémoire.

Selon un mode de réalisation de l'invention, pour chaque cellule mémoire, disposée entre deux autres cellules mémoire adjacentes de la même rangée, les sources et les drains de premier et troisième transistors sont alignés le long d'un bord commun entre la cellule mémoire et l'une des cellules mémoire adjacentes.

Selon un mode de réalisation de l'invention, chaque cellule mémoire est reliée à une ligne d'alimentation à une deuxième tension correspondant à une bande conductrice du même niveau que les lignes de bits, parallèle aux lignes de bits et disposée entre les lignes de bits.

Selon un mode de réalisation de l'invention, pour chaque cellule mémoire, disposée entre deux autres cellules mémoire adjacentes de la même colonne, la source ou le drain de premier et deuxième transistors et la source ou le drain d'un troisième transistor sont alignés le long d'un bord commun entre la cellule mémoire et l'une des cellules mémoire adjacentes.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1, décrite précédemment, représente de façon schématique une cellule d'une mémoire SRAM classique ;
la figure 2, décrite précédemment, représente de façon schématique une rangée d'une mémoire SRAM classique à une ligne de mots par rangée ;
la figure 3, décrite précédemment, représente de façon schématique une rangée d'une mémoire SRAM classique à deux lignes de mots par rangée ;
la figure 4, précédemment décrite, représente de façon schématique un exemple de topologie classique d'une cellule d'une mémoire SRAM à une ligne de mots par rangée ;
la figure 5, précédemment décrite, représente de façon schématique un exemple de topologie classique d'une cellule d'une mémoire SRAM à deux lignes de mots par rangée ;
la figure 6 représente un mode de réalisation d'une cellule d'une mémoire SRAM à deux lignes de mots par rangée selon l'invention et
les figures 7, 8, 9 représentent respectivement des sections schématiques de la figure 6 selon les lignes VII-VII, VIII-VIII et IX-IX.

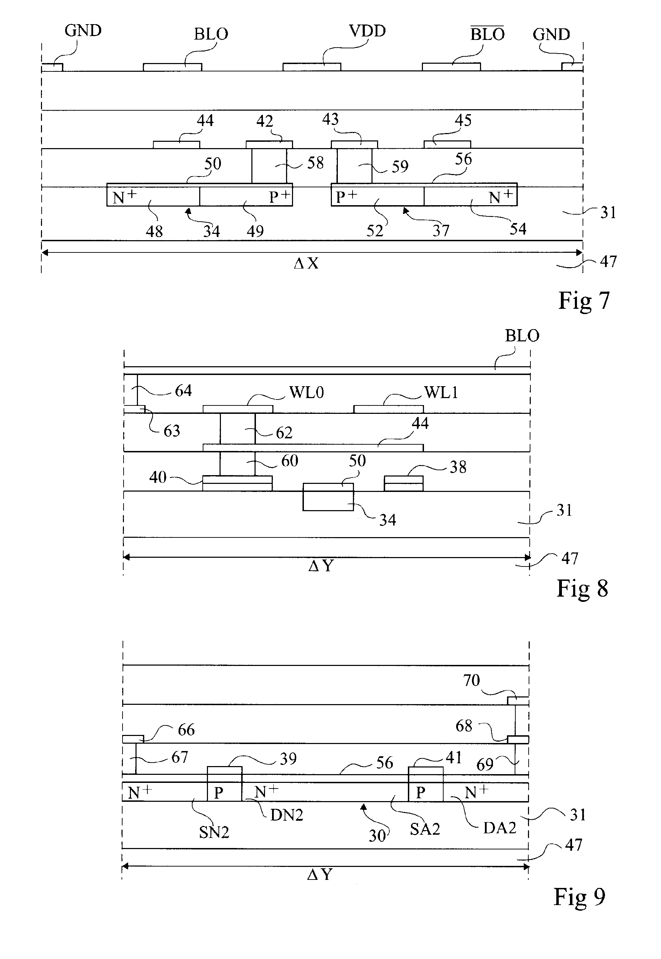

On notera que dans les figures 7 à 9, comme cela est habituel dans le domaine de la représentation de circuits intégrés, les épaisseurs et dimensions latérales des diverses couches, bandes, pistes, etc. ne sont pas tracées à l'échelle ni à l'intérieur d'une même figure, ni d'une figure à l'autre pour améliorer la visibilité de cette figure. Par ailleurs, de mêmes références désigneront, sur les différentes figures, de mêmes éléments.

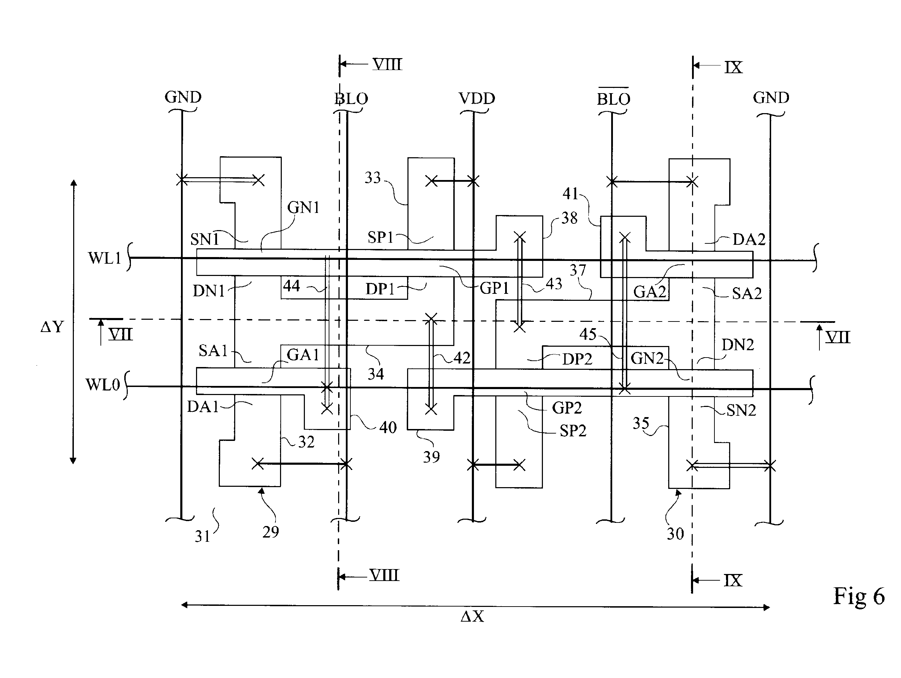

La figure 6 représente un exemple de réalisation d'une cellule 6T d'une mémoire SRAM à deux lignes de mots par rangée. La cellule mémoire est réalisée sur un substrat du type substrat sur isolant (SOI) et comprend deux zones actives 29, 30 de silicium monocristallin dopé isolées l'une de l'autre par un matériau isolant 31. Les zones actives 29, 30 sont sensiblement symétriques par rapport au centre de la cellule mémoire.

La zone active 29 comprend une première portion verticale 32 correspondant au transistor N1, au transistor A1 et à la liaison entre ces transistors, une seconde portion verticale 33 correspondant au transistor P1, et une portion horizontale 34 contenant une jonction PN et reliant les portions verticales 32, 33. De façon similaire, la zone active 30 comprend une première portion verticale 35 correspondant au transistor N2, au transistor A2 et à la liaison entre ces transistors, une seconde portion verticale 36 correspondant au transistor P2 et une portion horizontale 37 contenant une jonction PN reliant les deux portions verticales 35, 36. Un matériau conducteur (non représenté), par exemple du siliciure, recouvre chaque zone active 29, 30 au niveau des drains DP1, DN1, DP2, DN2 des transistors P1, N1, P2, N2, des sources SA1, SA2 des transistors A1, A2 et des portions horizontales 34, 37.

Les grilles GN1, GP1 des transistors N1, P1 correspondent à des portions d'une bande de silicium 38 horizontale. Les grilles GN2, GP2 des transistors N2, P2 correspondent à des portions d'une bande de silicium 39 horizontale. Les grilles GA1, GA2 des transistors A1, A2 correspondent à des portions respectives de deux bandes de silicium polycristallin 40, 41 horizontales.

Le drain DP1 du transistor P1 est relié à la bande de silicium polycristallin 39 par l'intermédiaire d'une piste métallique verticale 42 de niveau un. Le drain DP2 du transistor P2 est relié à la bande de silicium polycristallin 38 par l'intermédiaire d'une piste métallique verticale 43 de niveau un.

Les lignes d'alimentation GND, VDD et les lignes de bits **BL0, $\overline{\text{BL0}}$** correspondent à des bandes métalliques verticales de niveau trois reliées aux zones actives 29, 30 par des contacts, des vias et des pistes ou portions métalliques de niveaux un et deux.

Deux lignes de mots WL0, WL1 sont formées par deux bandes métalliques horizontales de niveau deux. Deux pistes métalliques verticales 44, 45 de niveau un s'étendent sensiblement chacune sous les lignes de mots WL0, WL1 et permettent de connecter les grilles GA1, GA2 des transistors A1, A2 à l'une des lignes de mots WL0, WL1. Dans le présent exemple, les grilles GA1, GA2 des transistors A1, A2 sont connectées à la ligne de mots WL0.

La figure 7 représente une section de la figure 6 selon la ligne VII-VII. Comme on peut le voir plus clairement sur cette figure, le matériau isolant 31 est formé sur un substrat 47, par exemple en silicium. La portion horizontale 34 de la zone active 29 se divise en une partie dopée N 48 et une partie dopée P 49 qui sont recouvertes d'une couche de siliciure 50. De même, la portion horizontale 37 de la zone active 30 se divise en une partie dopée P 52 et une partie dopée N 54 qui sont recouvertes d'une couche de siliciure 56. La piste 42 de niveau un est reliée à la portion horizontale 34 par un contact 58. La piste 43 de niveau un est reliée à la portion horizontale 37 par un contact 59.

Les lignes de bits **BL0, $\overline{\text{BL0}}$** et les lignes d'alimentation GND, VDD correspondent à des bandes métalliques verticales équiréparties de niveau trois. En particulier, les lignes d'alimentation GND sont disposées au niveau des bords verticaux droit et gauche de la cellule mémoire et sont mises en commun avec les cellules mémoire adjacentes de la même rangée.

La figure 8 représente une section de la figure 6 selon la ligne VIII-VIII. La bande de silicium polycristallin 40 est connectée à la piste métallique 44 de niveau un par un contact 60. La piste métallique 44 est elle-même connectée à la ligne de mots WL0 par un via 62. La ligne de bits **BL0** est connectée à une piste métallique 63 de niveau deux par un via 64. Le via 64 et la piste 63 sont disposés au niveau du bord horizontal inférieur de la cellule mémoire et sont mis en commun avec la cellule mémoire adjacente de la même colonne au-dessous de la cellule représentée.

La figure 9 représente une coupe de la figure 6 selon la ligne IX-IX. La zone active 30 correspondant aux transistors A2, N2 est connectée, du côté de la source SN2 du transistor N2, à une piste métallique horizontale 66 de niveau un par un contact 67, la piste 66 étant destinée à être reliée à la ligne d'alimentation GND située le long du bord vertical droit de la cellule mémoire. La piste 66 et le via 67 sont disposés au niveau du bord horizontal inférieur de la cellule mémoire et sont mis en commun avec la cellule adjacente de la même colonne au-dessous de la cellule représentée. La zone active 30 est également connectée, du côté du drain DA2 du transistor A2 à une portion métallique 68 de niveau un par un contact 69, la portion métallique 68 étant elle-même reliée à une piste métallique horizontale 70 de niveau deux qui est reliée à la ligne de bits $\overline{\text{BL0}}$. Les portion 68 et piste 70 métalliques, le contact 69 et le via 70 sont disposés au niveau du bord horizontal supérieur de la cellule mémoire et sont mis en commun avec la cellule adjacente de la même colonne au-dessus de la cellule représentée.

La présente invention permet de réduire la surface de la cellule par la mise en commun d'éléments avec les cellules adjacentes.

Les drains DA1, DA2 des transistors A1, A2 sont disposés du côté des bords horizontaux de la cellule mémoire afin de réaliser des contacts, vias et portions métalliques assurant la connexion entre les transistors A1, A2 et les lignes de bits **BL0, $\overline{\text{BL0}}$** communs pour des cellules mémoire adjacentes d'une même colonne. De façon analogue, les sources SP1, SP2 des transistors P1, P2 sont disposées du côté des bords verticaux de la cellule mémoire afin de réaliser des contacts, vias et portions métalliques assurant la connexion entre les transistors P1, P2 et la ligne d'alimentation VDD communs entre deux cellules adjacentes d'une même colonne. De plus, les sources SN1, SN2 des transistors N1, N2 sont disposées à proximité des coins de la cellule mémoire, ce qui permet de placer les lignes d'alimentation GND au niveau des bords verticaux de la cellule. On peut donc mettre en commun une ligne d'alimentation GND entre deux cellules mémoire adjacentes de la même rangée, et réaliser des contacts, vias et portions métalliques assurant la connexion entre l'un des transistors N1, N2 et une ligne d'alimentation GND communs entre quatre cellules ayant un coin en commun.

La cellule mémoire étant réalisée sur un substrat SOI, il est possible d'utiliser les portions horizontales 34, 37 court-circuitées par les couches de siliciure 50, 56 pour réaliser la connexion entre respectivement les drains DP1, DP2 des transistors P1, P2 et les drains DN1, DN2 des transistors N1, N2. Ceci permet de supprimer les pistes métalliques de niveau un et les contacts associés qui sont habituellement utilisées pour réaliser de telles connexions. Les pistes métalliques verticales 44, 45 participant à la connexion entre les grilles GA1, GA2 des transistors A1, A2 et les lignes de mots WL0, WL1 peuvent être réalisées par des pistes de niveau un et les lignes WL0, WL1 de mots par des bandes métalliques de niveau deux.

A l'exception des pistes métalliques de niveau un participant à la connexion entre les lignes d'alimentation GND et les transistors N1, N2, et entre la ligne d'alimentation VDD et les transistors P1, P2, toutes les pistes métalliques de niveau un sont disposées verticalement, ce qui permet de réduire la hauteur de la cellule mémoire selon l'invention.

Pour une cellule mémoire à une seule ligne de mots par rangée conservant une topologie semblable à celle de la figure 6, on obtient une largeur $\Delta X$ de 2,56 µm, une hauteur $\Delta Y$ de 1,10 µm et une surface de 2,816 µm$^2$. La surface obtenue est donc inférieure de 8,6% à la surface de la cellule de la figure 4. Pour la cellule mémoire à deux lignes de mots par rangée selon la figure 6, on obtient une largeur $\Delta X$ de 2,56 µm, une hauteur $\Delta Y$ de 1,12 µm, et une surface de 2,8672 µm$^2$. La hauteur et la surface de la cellule de la mémoire "multi-lignes" varient donc peu par rapport à la cellule de la mémoire à une ligne de mots par rangées. En outre, la hauteur $\Delta Y$ obtenue est inférieure de 27% à la hauteur de la cellule de la figure 5, permettant de réduire les capacités des lignes de bits et donc d'obtenir une cellule mémoire "multi-ligne" à faible temps de lecture et d'écriture.

Selon une variante de l'invention, les lignes de mots peuvent correspondre à des bandes métalliques de niveau trois. Les lignes de bits et les lignes d'alimentation peuvent alors correspondre à des bandes métalliques de niveau deux. Dans ce cas, les surfaces d'une cellule mémoire à une seule ligne de mots par rangée et d'une cellule mémoire à deux lignes de mots par rangée sont sensiblement identiques aux valeurs indiquées précédemment.

Bien entendu, la présente invention est susceptible de diverses variantes et modifications qui apparaîtront à l'homme de l'art. En particulier, la réalisation de la cellule mémoire a été décrite comme mettant en oeuvre un niveau de silicium polycristallin et trois niveaux de métallisation. Il est tout à fait possible de remplacer les bandes métalliques d'un ou plusieurs niveaux de métallisation par un autre matériau conducteur. Par exemple, le premier niveau de métallisation peut être remplacé par un niveau deux de silicium polycristallin dopé. En outre, les grilles des transistors peuvent être réalisées dans un matériau conducteur autre que du silicium polycristallin. Il peut s'agir, par exemple, d'un métal. De plus, les interrupteurs des points mémoires peuvent être réalisés par des transistors MOS à canal P en faisant les adaptations nécessaires.

## Revendications

1. Mémoire SRAM comprenant un réseau de rangées et de colonnes de cellules mémoire 6T à deux inverseurs et deux transistors interrupteurs formées dans un substrat du type silicium sur isolant, les entrées des deux inverseurs (1, 2) de chaque cellule mémoire étant reliées à deux lignes de bits **(BL0, $\overline{BL0}$)** par l'intermédiaire des deux transistors interrupteurs (3) commandés par un signal fourni par une ligne de mots (WL0, WL1), chaque cellule mémoire comportant six transistors (Ni, P1, A1, N2, P2, A2) dont les grilles (GN1, GP1, GA1, GN2, GP2, GA2) correspondent à un même niveau d'un premier matériau conducteur et dont les interconnexions sont réalisées par des pistes conductrices d'au moins un deuxième matériau conducteur réparties sur trois niveaux, chaque inverseur comprenant un premier transistor (N1, N2) d'un premier type de conductivité et un deuxième transistor (P1, P2) d'un second type de conductivité, chaque interrupteur comprenant un troisième transistor (A1, A2) du premier type de conductivité, **caractérisée en ce que** chaque cellule mémoire comprend deux premières régions (48, 54) du premier type de conductivité, chaque première région comprenant les drains ou les sources d'un premier (N1, N2) et d'un troisième (A1, A2) transistors, et étant en contact avec une seconde région (49, 52) du second type de conductivité comprenant le drain ou la source d'un deuxième transistor (P1, P2), les première et seconde régions associées étant court-circuitées par un troisième matériau conducteur recouvrant lesdites première et seconde régions, la ligne de mots et les lignes de bits correspondant à des bandes conductrices de niveaux supérieurs au premier niveau, les pistes conductrices (42, 43, 44, 45) de premier niveau participant aux interconnexions entre les inverseurs, et aux interconnexions entre les transistors interrupteurs et la ligne de mots étant parallèles aux lignes de bits.

2. Mémoire selon la revendication 1, dans laquelle une unique ligne de mots correspondant à une bande métallique de niveau deux ou trois est associée à une rangée, chaque cellule mémoire de la rangée étant reliée à ladite ligne de mots, les lignes de bits (BL0, $\overline{BL0}$ ) correspondant à des bandes métalliques perpendiculaires à la ligne de mots et d'un niveau différent du niveau de la ligne de mots.

3. Mémoire selon la revendication 1, dans laquelle au moins deux lignes de mots (WL0, WL1), correspondant à des bandes métalliques de niveau deux ou trois, sont associées à une rangée, chaque cellule mémoire de la rangée étant reliée à l'une des lignes de mots, les lignes de bits (BL0, $\overline{BL0}$) correspondant à des bandes métalliques perpendiculaires aux lignes de mots et d'un niveau différent du niveau des lignes de mots.

4. Mémoire selon la revendication 3, dans laquelle chaque cellule mémoire comporte au moins une piste conductrice (44, 45) de niveau un perpendiculaire aux lignes de mots (WL0, WL1) et connectée à l'une des lignes de mots et à l'un des troisièmes transistors (A1, A2).

5. Mémoire selon la revendication 1, dans laquelle chaque cellule mémoire, disposée entre deux autres cellules mémoire adjacentes de la même rangée, est reliée à deux lignes d'alimentation (GND) à une première tension, chaque ligne d'alimentation étant partagée entre la cellule mémoire et l'une des cellules mémoire adjacentes et correspondant à une bande conductrice du même niveau que les lignes de bits (BL0, $\overline{BL0}$), parallèle aux lignes de bits et disposée sur le bord commun entre deux cellules adjacentes.

6. Mémoire selon la revendication 1, dans laquelle les sources et les drains de premier (N1, N2) et troisième (A1, A2) transistors sont alignés parallèlement aux lignes de bits (BL0, $\overline{BL0}$ ).

7. Mémoire selon la revendication 1, dans laquelle chaque cellule mémoire comporte deux zones actives (29, 30), chaque zone active comprenant l'une des premières régions (48, 54) et la seconde région (49, 52) associée, les zones actives étant sensiblement symétriques par rapport au centre de la cellule mémoire.

8. Mémoire selon la revendication 1, dans laquelle, pour chaque cellule mémoire, disposée entre deux autres cellules mémoire adjacentes de la même rangée, les sources (SN1, SA1, SN2, SA2) et les drains (DN1, DA1, DN2, DA2) de premier (N1, N2) et troisième (A1, A2) transistors sont alignés le long d'un bord commun entre la cellule mémoire et l'une des cellules mémoire adjacentes.

9. Mémoire selon la revendication 5, dans laquelle chaque cellule mémoire est reliée à une ligne d'alimentation (VDD) à une deuxième tension correspondant à une bande conductrice du même niveau que les lignes de bits (BL0, $\overline{BL0}$), parallèle aux lignes de bits et disposée entre les lignes de bits.

10. Mémoire selon la revendication 1, dans laquelle, pour chaque cellule mémoire, disposée entre deux autres cellules mémoire adjacentes de la même colonne, la source (SN1, SN2, SP1, SP2) ou le drain (DN1, DN2, DP1, DP2) de premier et deuxième transistors (Ni, N2, P1, P2) et la source (SA1, SA2) ou le drain (DA1, DA2) d'un troisième transistor (A1, A2) sont alignés le long d'un bord commun entre la cellule mémoire et l'une des cellules mémoire adjacentes.

Fig 1

Fig 2

Fig 3

Fig 4

GND    BLO    VDD    $\overline{BLO}$    GND

13

16

SN1        GN1    SP1                DA2
                                            20
DN1              GP1        GA2
GA1              DP1                SA2
WL0                                DN2
        SA1        DP2
DA1                        SP2    GN2    SN2
        19    GP2        18

11              14              12

$\Delta Y$    $\Delta X$

EP 1 388 896 A1

9

Fig 5

GND  BLO  VDD  $\overline{BLO}$  GND

WL1

WL0

$\Delta Y$

$\Delta X$

SN1  SP1  DA2
GN1  20  26
DN1  GP1  GA2
DP1  SA2
GA1  SA1  19  23  24  DN2
DA1  DP2
25  GP2  SP2  GN2
SN2

EP 1 388 896 A1

Fig 6

EP 1 388 896 A1

GND    BLO    VDD    $\overline{BLO}$    GND

44    42    43    45

50    58    59    56

N⁺    P⁺    P⁺    N⁺    31

48    34    49    52    37    54

ΔX    47

Fig 7

BLO

64    WL0    WL1

63    62    44

40    60    50    38

34    31

ΔY    47

Fig 8

70

66    68

67    56    41    69

N⁺    P    N⁺    P    N⁺

SN2    DN2    30    SA2    DA2    31

ΔY    47

Fig 9

**Office européen des brevets**

# RAPPORT DE RECHERCHE EUROPEENNE

Numéro de la demande

EP 03 30 0083

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 886 388 A (KURIYAMA HIROTADA ET AL) 23 mars 1999 (1999-03-23) | 1-3,5-7, 9 | H01L27/12 H01L27/11 |
| A | * le document en entier * | 4,8,10 | |
| A | GB 2 332 779 A (SAMSUNG ELECTRONICS CO LTD) 30 juin 1999 (1999-06-30) * le document en entier * | 1,2,5-10 | |
| A | PATENT ABSTRACTS OF JAPAN vol. 017, no. 596 (P-1636), 29 octobre 1993 (1993-10-29) & JP 05 174580 A (SONY CORP), 13 juillet 1993 (1993-07-13) * abrégé * | 3 | |
| A | FR 2 777 686 A (MITSUBISHI ELECTRIC CORP) 22 octobre 1999 (1999-10-22) * le document en entier * | 1,2,5-10 | |

**DOMAINES TECHNIQUES RECHERCHES (Int.Cl.7)**

H01L

Le présent rapport a été établi pour toutes les revendications

| Lieu de la recherche | Date d'achèvement de la recherche | Examinateur |
|---|---|---|
| La Haye | 24 novembre 2003 | Albrecht, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)

**ANNEXE AU RAPPORT DE RECHERCHE EUROPEENNE
RELATIF A LA DEMANDE DE BREVET EUROPEEN NO.**

EP 03 30 0083

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-11-2003

| Document brevet cité au rapport de recherche | | Date de publication | Membre(s) de la famille de brevet(s) | | Date de publication |
|---|---|---|---|---|---|
| US 5886388 | A | 23-03-1999 | JP | 11045949 A | 16-02-1999 |
| GB 2332779 | A | 30-06-1999 | DE | 19832795 A1 | 01-07-1999 |
| | | | GB | 2349274 A ,B | 25-10-2000 |
| | | | JP | 11195716 A | 21-07-1999 |
| | | | TW | 396619 B | 01-07-2000 |
| | | | US | 6147385 A | 14-11-2000 |
| JP 05174580 | A | 13-07-1993 | AUCUN | | |
| FR 2777686 | A | 22-10-1999 | JP | 11297856 A | 29-10-1999 |
| | | | CN | 1232296 A | 20-10-1999 |
| | | | FR | 2777686 A1 | 22-10-1999 |
| | | | TW | 396603 B | 01-07-2000 |
| | | | US | 2002067636 A1 | 06-06-2002 |
| | | | US | 2002003241 A1 | 10-01-2002 |

EPO FORM P0460